# EUROPEAN PATENT APPLICATION

(11) **EP 0 805 489 A2**
(43) Date of publication of application: **05.11.1997**
(21) Application number: 97107036.2
(22) Date of filing: 29.04.1997
(51) Int. Cl.: H01L 21/768

(54) **Selective via fill using a sacrificial layer**

(30) Priority: 29.04.1996 US 639558
(71) Applicant: APPLIED MATERIALS, INC., Santa Clara, California 95052 (US)
(72) Inventor: Chen, Lian-Yuh, San Jose, California 95131 (US); Guo, Ted Tie, Palo Alto, California 94303 (US); Hoinkis, Mark, San Jose, California 95131 (US); Mosely, Roderick Craig, Pleasanton, California 94588 (US); Naik, Mehul Bhagubhai, Sunnyvale, California 94086 (US); Zhang, Hong, Fremont, California 94539 (US)
(74) Representative: Kahler, Kurt, Dipl.-Ing.

(57) **Abstract**

The present invention relates generally to an improved apparatus and process for providing uniform step coverage on a substrate and planarization of metal layers to form continuous, void-free contacts or vias in sub-half micron aperture width applications. In one aspect of the invention, a dielectric layer (32) is formed over a conducting member (36). A thin sacrificial layer (34) is then deposited onto the dielectric layer (32) prior to etching high aspect ratio apertures through the sacrificial and dielectric layers (34, 32) to expose the underlying conducting member (36) on the aperture floor (42). A CVD metal layer is then deposited onto the structure (30) to achieve selective deposition within the apertures. The sacrificial film (34) is then etched to remove any nodules (45) formed thereon.

## Description

### BACKGROUND OF THE INVENTION

### Field of the Invention

The present invention relates to a metallization method and apparatus for manufacturing semiconductor devices. More particularly, the present invention relates to selective metallization of apertures in insulative layers to form void-free interconnects between conducting layers, including apertures such as contacts or vias in high aspect ratio sub-half micron applications, utilizing a sacrificial film to eliminate the loss of selectivity on the field.

### Background of the Related Art

Sub-half micron multilevel metallization is one of the key technologies for the next generation of very large scale integration ("VLSI"). The multilevel interconnects that lie at the heart of this technology require planarization of interconnect features formed in high aspect ratio apertures, including contacts, vias, lines or other features. Reliable formation of these interconnect features is very important to the success of VLSI and to the continued effort to increase circuit density and quality on individual substrates and die.

Two conventional methods for depositing Aluminum (Al) by chemical vapor deposition ("CVD") include a blanket process and a selective process. CVD processes typically involve the deposition of a film layer which occurs when a component of the chemical vapor contacts a "nucleation site" on the substrate. The component deposits at the nucleation site, creating a metal surface on which further deposition proceeds. A blanket CVD process typically deposits a film on all exposed surfaces of the substrate, including inside of the apertures and on the field because the entire substrate surface serves as a nucleation layer. Selective deposition processes typically deposit material only on exposed nucleation surfaces wherever provided on the substrate surface.

Blanket CVD metal deposition, such as CVD Al, where a metal film is deposited on all exposed surfaces of the substrate, usually requires the presence of an electrically conductive nucleation layer. Thin metal films deposited during a blanket CVD process are usually conformal and provide excellent step coverage, i.e., uniform thickness of layers on the sides and base of any aperture extending into the exposed surface of the substrate, even for very small aperture geometries. Therefore, CVD of aluminum is a common method used to fill apertures. However, there are two primary difficulties associated with filling high aspect ratio (height to width 2:1 or greater) apertures to form vias or contacts using blanket CVD methods. First, CVD films grow from all sides in an aperture and may form a void in the filled aperture comprising the via or contact which may compromise the integrity of the device. The formation of voids within these apertures is commonly referred to as crowning because the deposited layer grows upwardly and outwardly at the upper corners of the aperture and bridges at this location before the aperture has been completely filled creating a void therein. Second, the deposition of a nucleation layer on the aperture walls to ensure deposition of the CVD layer thereon further reduces the width of the aperture, which compounds the problems encountered when filling high aspect ratio apertures without voids.

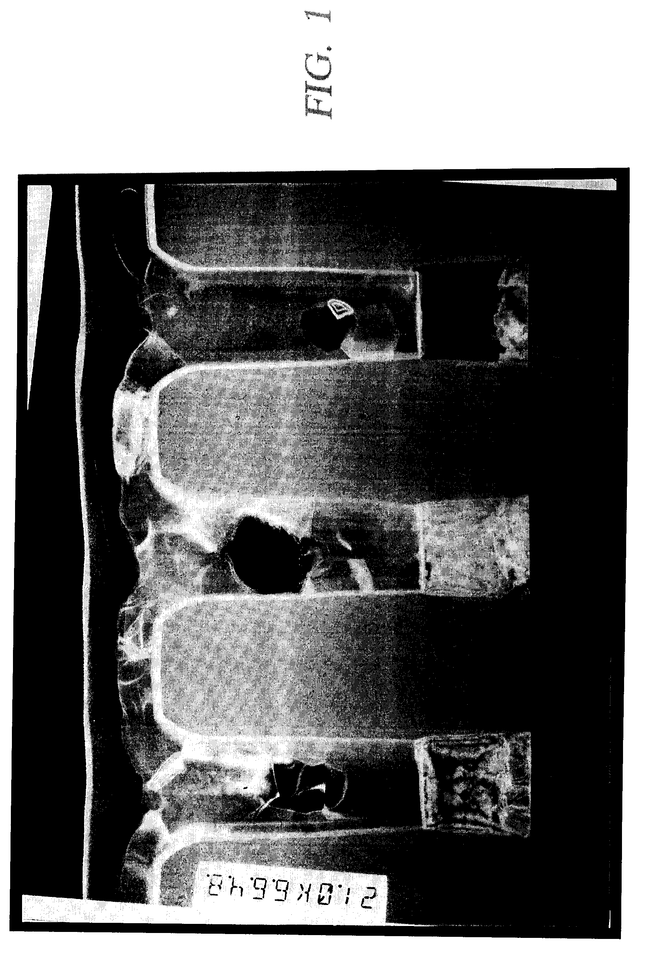

Recent transmission electron microscopy data ("TEM") reveal that voids exist in many interconnects formed by both CVD and PVD Al processes even though standard electric tests of these interconnects do not evidence the existence of this void. Referring to Figure 1, a TEM photograph shows a cross-sectional image of a 0.45 micron via filled with CVD Al. The image clearly indicates that voids exist in the metal layer deposited within the via structure. It should be recognized that this void is very difficult to detect by regular cross sectional standard electron microscopy ("SEM") techniques, because some deformation occurs in soft aluminum during mechanical polishing of the slide preparation. In addition, electric conductivity tests many times do not detect structural abnormalities such as voids, because the metal forms a bridging layer through at least a portion of the aperture. However, despite the generally positive electric conductivity tests, conduction through a contact having a void may, over time, compromise the integrity of the integrated circuit devices in which the void is formed.

A TEM study of various CVD Al layers formed on substrates indicates that the voids typically occur in a key hole pattern wherein the top portion of the via becomes sealed before the via has been entirely filled, i.e., crowning. Although a thin conformal layer of CVD Al can typically be deposited in high aspect ratio apertures to form contacts and vias at low temperatures, continued CVD deposition to completely fill the apertures typically results in the formation of voids therein. Extensive efforts have been focused on eliminating the voids in metal layers by modifying CVD processing steps and parameters.

Selective CVD Al deposition is based on the fact that the decomposition of a CVD Al precursor gas usually requires a source of electrons from a conductive nucleation film. In accordance with a conventional selective CVD Al deposition process, Al should grow in the bottom of an aperture where either a metal film or doped silicon or metal silicide from the underlying conductive layer has been exposed, but should not grow on dielectric surfaces such as the field and aperture walls. The underlying metal films or doped silicon are electrically conductive, unlike the dielectric field and aperture walls, and supply the electrons needed for decomposition of the Al precursor gas and the resulting deposition of Al. The result obtained through selective deposition is an epitaxial "bottom-up" growth of CVD Al in the apertures capable of filling very small dimension (<0.25 µm), high aspect ratio (>5:1) via or contact openings.

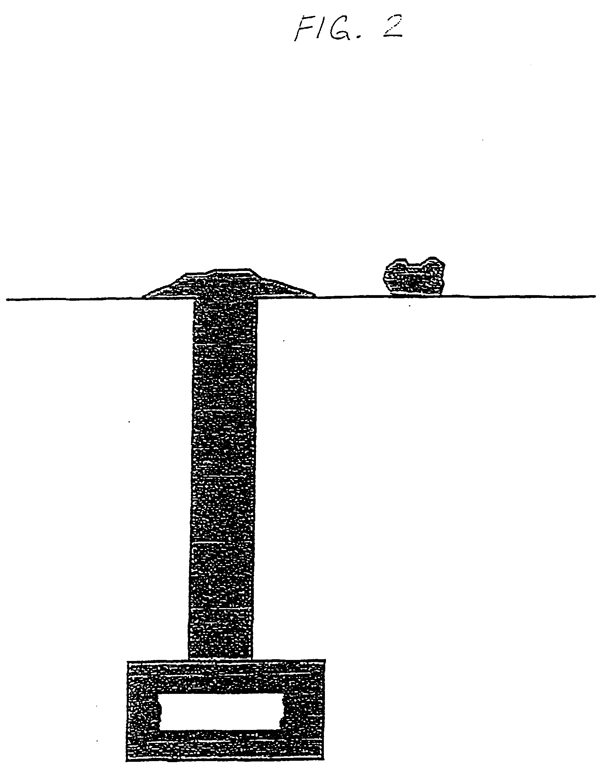

Referring to Figure 2, a schematic diagram of an integrated circuit structure 10 shows a metal interconnect formed in via 14 that was selectively nucleated by the conducting member 18 and grew uniformly upward towards the surface 20 of the dielectric layer 16. However, in actual practice of the selective deposition process, there are almost always defects on the surface of the dielectric layer and on the sidewalls of the apertures which provide free electrons and thus also serve as nucleation sites for CVD Al growth, causing unwanted nodule 12 formation on the surface 20 and the walls of the apertures. Note that a nodule 12 was formed on the dielectric field by loss of selectivity during a conventional selective CVD process to fill the via or contact 14.

Various methods have been used to minimize the loss of selectivity that leads to nodule formation, especially in selective tungsten (W) technology. These methods have included, for example, preconditioning of the wafer surface before the selective deposition process and chemical mechanical polishing (CMP) of the surface following the selective deposition process to remove any nodules 12 which form on the wafer surface 20 during selective deposition. However, these methods complicate the processing steps required to form the desired circuit structures and significantly increase the expense of the integrated circuit manufacturing process. In addition, adding steps to the overall process increases the likelihood that defects may result in the formed structures.

Therefore, there remains a need for a selective metallization process for void-free filling of apertures, particularly high aspect ratio, sub-quarter micron wide apertures for forming contacts and vias. More particularly, it would be desirable to have a simple process requiring fewer processing steps to accomplish selective deposition in vias or contacts without nodule formation on the field caused by the loss of selectivity.

### SUMMARY OF THE INVENTION

The present invention provides a method and apparatus for forming an interconnect on a substrate having a dielectric layer covering at least a first conducting member, comprising the steps of forming a sacrificial layer over the surface of the dielectric, etching an aperture through the sacrificial layer and the dielectric layer to form an aperture having a floor which exposes a portion of a conducting or semi-conducting member and selectively depositing a metal by chemical vapor deposition or electroplating in the aperture. The sacrificial layer, on which nodules may be formed, is then removed using solvents or by etching, depending on the material used as the sacrificial layer. The sacrificial layer may be formed of a photoresist, polymer, or dielectric.

Another aspect of the invention provides a method and apparatus for preventing nodule formation on a first surface during selective deposition of metals on a second surface, the method comprising the steps of forming a sacrificial layer on the first surface to provide selective growth of a deposited film on the second surface.

### BRIEF DESCRIPTION OF THE DRAWINGS

So that the manner in which the above recited features, advantages and objects of the present invention are attained can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefor not to be considered limiting of its scope, for the invention may admit to other equally effective embodiments.
Figure 1 is a transmission electron microscopy photograph showing a cross-section of a semiconductor substrate via having voids therein;
Figure 2 is a schematic diagram showing the nodule formation caused by loss of selectivity in conventional selective chemical vapor deposition processes;
Figure 3 is a cross-sectional diagram of a layered structure including a dielectric layer and a sacrificial layer formed sequentially over an electrically conducting member or layer;
Figure 4 is a cross-sectional diagram of the structure of Figure 3 with a resist layer coating the sacrificial layer;
Figure 5 is a cross-sectional diagram of the resist layer of Figure 4 having been patterned by exposure to radiation through a patterned mask and developed to produce defined areas without resist;
Figure 6 is a cross-sectional diagram of an aperture etched into the sacrificial layer and the dielectric layer of Figure 5 is shown
Figure 7 is a a cross-sectional diagram of a via or contact etched into the sacrificial layer and dielectric layer in the structure of Figure 6;
Figure 8 is a cross-sectional view of a selectively deposited, void-free metal interconnect as formed on the structure of Figure 7;
Figure 9 is a cross-sectional view of the structure of Figure 8 after removal of the sacrificial layer;
Figure 10 is a transmission electron microscopy photograph showing a cross-section of a semiconductor substrate via formed by the selective process of the present invention;
Figure 11 is an integrated processing system configured for sequential metallization in accordance with the present invention; and
Figure 12 is a schematic flow diagram of a CVD gas box delivery system for supplying gases to the system of Figure 11.

### DETAILED DESCRIPTION OF A PREFERRED EMBODIMENT

The present invention generally provides a process and apparatus for the selective deposition of materials within small geometries, such as small apertures, to form vias or contacts between conducting layers. The process provides a sacrificial film formed on the surface of the substrate to substantially eliminate the loss of selectivity on the field and facilitate removal of any nodules which form on the sacrificial film. More particularly, the invention provides a method of selectively forming a conductive interconnect in a substrate having an underlying layer of a deposition enhancing material.

In one aspect of the invention, a sacrificial layer is formed over the surface of a substrate having an underlying layer of a material that can be used advantageously to enhance deposition thereon. Typically, the top surface or layer covering the substrate will be a dielectric material, such as silicon, and the underlying deposition enhancing material will be either a conductive metal or a conductive doped silicon. The sacrificial layer may be any material that can be removed from the dielectric layer or may even be a dielectric layer in low k polymer applications, but preferably will be an organic material that does not promote deposition thereon and can be easily removed by either a solvent or a dielectric etch process. It is preferred that the organic materials be stable under the typical conditions of chemical vapor deposition processes, such as temperatures between about 120° C and about 280° C. The most preferred sacrificial layer materials are organic materials including benzocyclobutene ("BCB") and polyimides (e.g., OCG Probimide series, DuPont Pyralin polyimide).

The preferred embodiment will be described below with reference to CVD of Al to form the interconnect. However, it is to be understood that the scope of the invention includes other metalization processes such as electroplating.

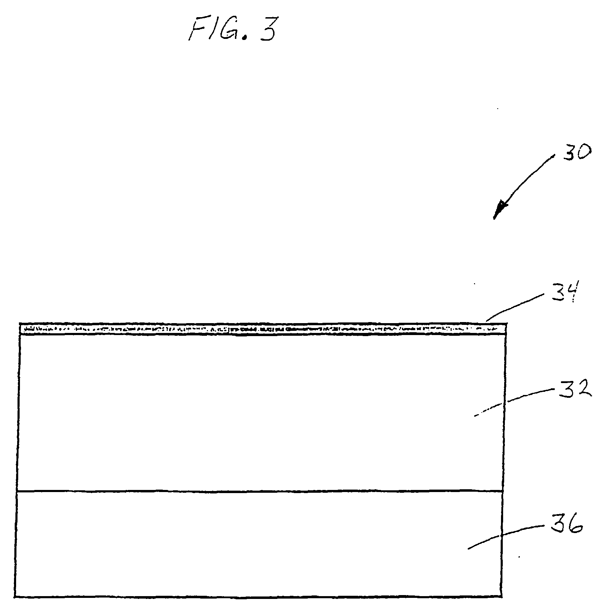

Referring to Figure 3, a cross-sectional diagram of a layered structure 30 is shown including a dielectric layer 32 and a sacrificial layer 34 formed sequentially over an electrically conducting member or layer 36. The electrically conducting member 36 may take the form of a doped silicon substrate or it may be a first or subsequent conducting layer formed on a substrate. The electrically conducting member 36 will typically be either a doped silicon layer or a conductive metal layer that has been previously patterned to form part of an integrated circuit device. The dielectric layer 32 is formed over the conducting member 36 in accordance with procedures known in the art to form a part of the overall integrated circuit.

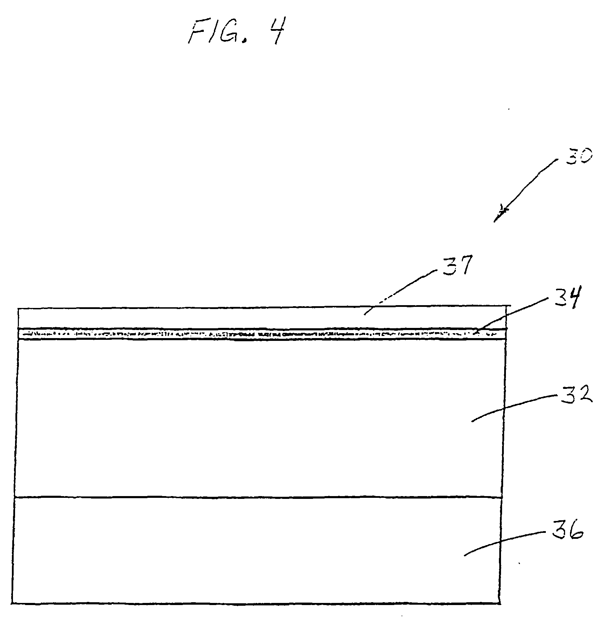

Referring to Figure 4, the structure 30 is shown with a resist layer 37 coating the sacrificial layer 34. The resist layer 37 may consist of any conventional resist material, but the preferred resists are photoresists or photoexpandable polyimides that can withstand the process temperatures of CVD deposition processes. One photoresist which can be used to advantage is Shipley DUV. Deposition of resists is well known to one of ordinary still in the art and other known resists can also be used to advantage in accordance with the present invention.

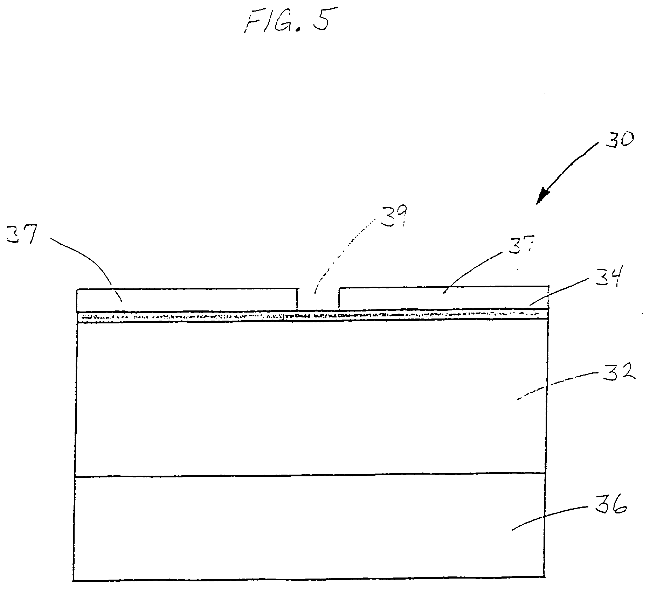

Referring to Figure 5, the resist layer 37 of structure 30 is patterned by exposure to radiation, such as ultraviolet light or x-rays, through a patterned mask (not shown) and developed to produce a defined area or window 39 without resist. The window 39 exposes the sacrificial layer 34 so that apertures can be etched therethrough and through the dielectric layer 32. The present invention specifically includes the use of positive or negative resists.

The sacrificial layer 34 and dielectric layer 32 are then etched to form an aperture having a floor exposing the deposition enhancing material or nucleation surface. Etching of the dielectric layer 32 to form the aperture may be accomplished with any dielectric etching process, including plasma etching. Specific techniques for etching silicon dioxide and organic materials may include the use of a C₂F₆ or CF₄ plasma or an O₂ or combination of O₂/CF₄, respectively.

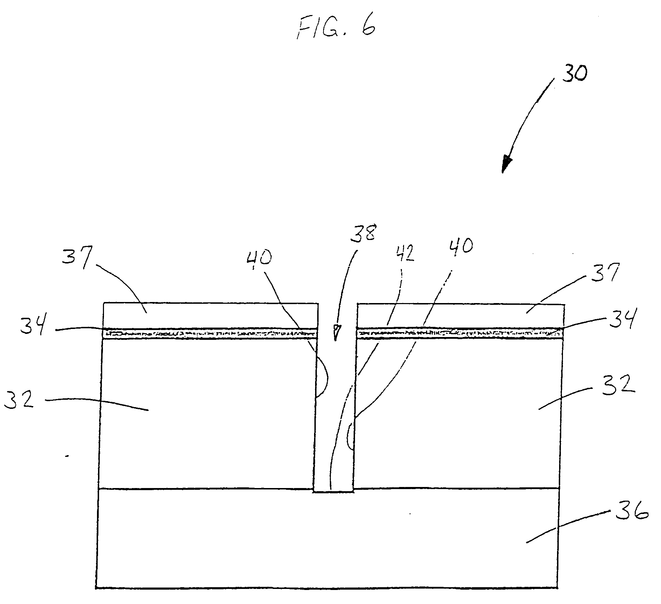

Referring to Figure 6, a cross-sectional diagram of an aperture 38 that has been etched into the sacrificial layer 34 and the dielectric layer 32 of Figure 5 is shown. The aperture 38 formed according to the present invention, is generally intended to facilitate the deposition of conductive interconnects that will provide an electrical connection with underlying conductive members. Therefore, the aperture 38 is typically etched through the dielectric layer 32 to form walls 40 and a floor 42 exposing at least a portion of the conductive member 36. The conductive member 36 may be a layer, wire or device comprising a metal, doped silicon or other conductive material. The presence of a conductive aperture floor is exploited according to the present invention to provide a selective deposition metal process which can include CVD or electroplating.

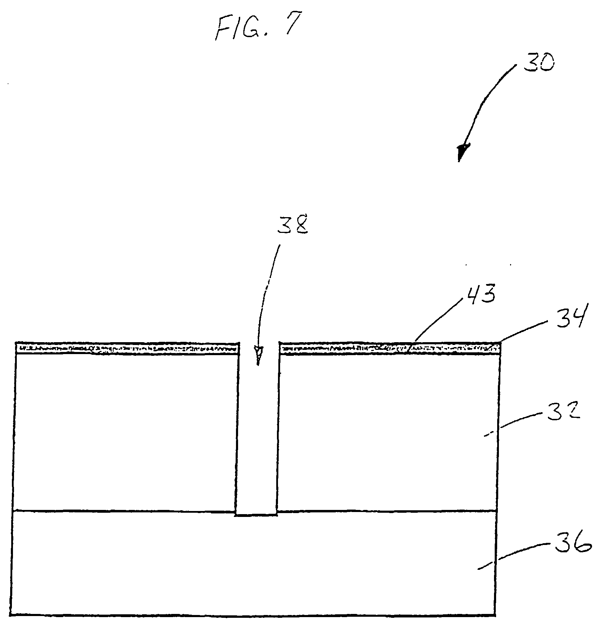

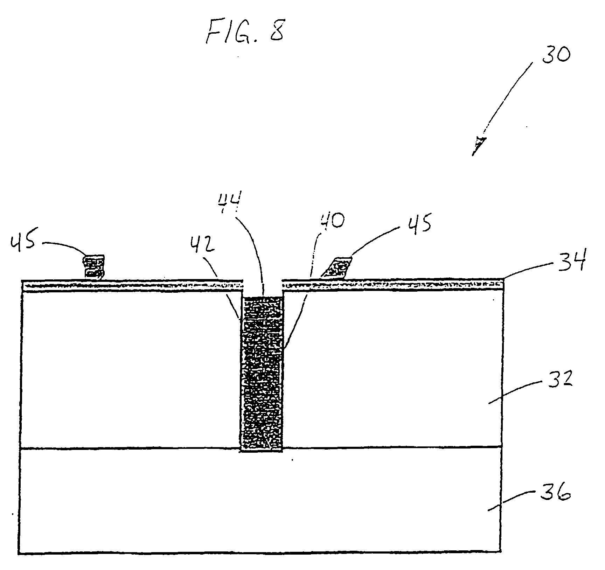

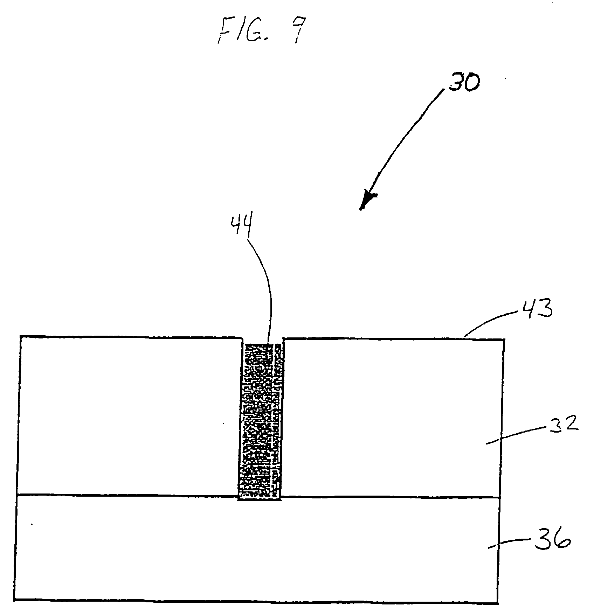

Referring to Figure 7, the structure 30 is shown, following removal of the resist layer 37 shown in Figure 6. The resist is removed following the etch process to leave a self-aligned sacrificial layer 34 around the aperture 38 formed in the sacrificial layer 34 and dielectric layer 32. The sacrificial layer 34 is left in place to shield the top surface 43 of the dielectric layer 32 from deposition of metal nodules thereon.

Certain CVD processes deposit metal films, such as aluminum (Al), based on the decomposition of a metal precursor. For example, a CVD Al film can be formed by the decomposition reaction of dimethyl aluminum hydride ("DMAH") with hydrogen gas (H₂). This particular reaction is believed to occur much more rapidly when the reactants come in contact with an electron donor, such as the surface of an electrically conductive material. Therefore, it is possible to achieve at least some measure of control or selectivity over where and how the CVD Al is deposited by preparing a structure with some surfaces that are conductive and some surfaces that are non-conductive. In a similar manner, the process of electroplating can enable selective deposition of materials such as copper on the electrically conductive material.

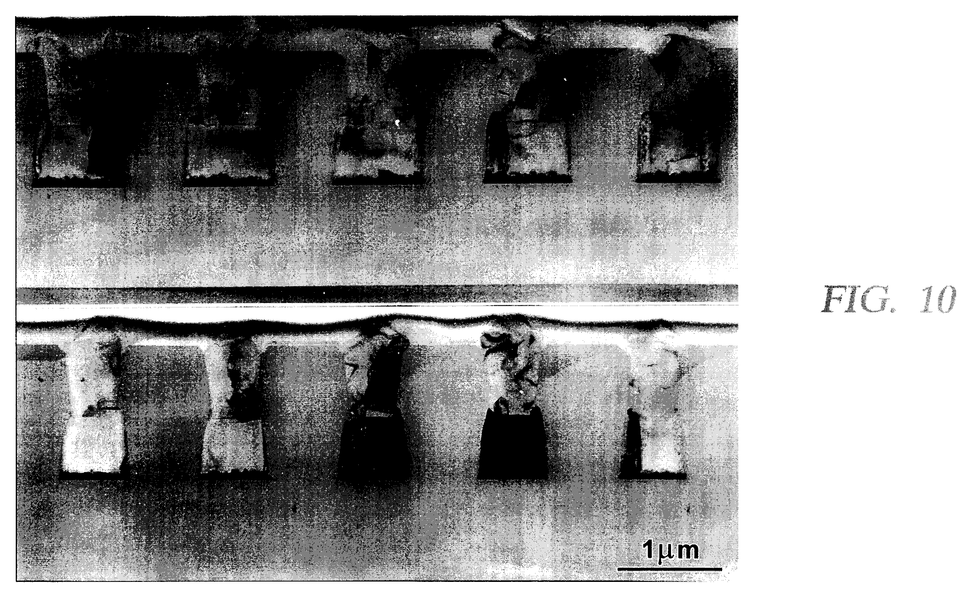

Referring to Figure 8, a cross-sectional view of a void-free metal interconnect 44 formed in aperture 38 is shown. Chemical vapor deposition of a metal on the patterned substrate provides selective deposition within the aperture 38 and the epitaxial growth of a void-free, single crystal interconnect 44. Despite the relative selectivity of the CVD Al, small amounts of the CVD Al can also deposit on the non-conductive sacrificial layer 34 to form nodules 45 thereon if the surface includes defects that can also serve as nucleation sites. While it is preferred that the sacrificial layer prevent or prohibit all deposition thereon, the sacrificial layer may allow even significant deposition thereon. However, the sacrificial layer and any material depositing thereon are easily removed as described below.

While the CVD Al may be deposited under various conditions, a typical process involves substrate temperatures of between about 120°C and about 280°C and a deposition rate of between about 20 Å/sec and about 130 Å/sec. The CVD Al deposition may be performed at chamber pressures of between about 1 torr and about 80 torr, with the preferred chamber pressure being about 25 torr. The preferred deposition reaction for CVD Al involves the reaction of dimethyl aluminum hydride ("DMAH") with hydrogen gas (H₂) according to the following equation:

6(CH₃)₂A*l -* H + 3H₂ → 6A*l* + 12CH₄

or

(CH₃)₂ A*l* - H → A*l* + 2 TMA (trimethyl aluminum) + H₂

The deposition within the aperture 38 to form metal interconnect 44 is selective because surface 42 of the underlying conductive layer 36 has been exposed to the CVD Al at the floor of the aperture 38. Therefore, the CVD Al is deposited from the floor 42 upward to fill the aperture 38 without any substantial CVD Al deposition on the aperture walls 40.

Furthermore, since the sacrificial layer 34 was deposited on the dielectric layer 32 prior to etching of the aperture 38, the aperture 38 comprises the substantially non-conductive dielectric walls 40 and the conductive floor 42. As discussed above, substantially non-conducting materials, such as the dielectric walls 40 of the aperture, are not good electron donors and, therefore, do not provide good nucleation for decomposition of the CVD metal precursor. Rather, the CVD metal film begins to form on the aperture floor 42 because the exposed conducting member 36 forming the floor of the aperture 38 nucleates the decomposition. After an initial layer of the metal has been deposited on the aperture floor 42, subsequent deposition occurs more easily so that the metal grows from the aperture floor 42 upward or outward to fill the aperture 38.

Although defects on the dielectric wall 40 of the aperture 38 may cause the formation of scattered nodules within the aperture, these nodules typically do not block the aperture to cause voids therein because nodule formation occurs at a much slower rate than selective growth. The aperture 38 is filled with metal from the floor upward before a nodule has an opportunity to grow across the aperture, thereby blocking a portion of the aperture from further deposition and forming a void therein, even in an aperture having an aspect ratio as high as 5:1, because the conducting aperture floor 42 exposes a large surface area compared to defect surface area of a nucleation material.

Referring to Figure 9, the sacrificial layer 34 is removed from the structure 30 following successful formation of the CVD Al interconnect 44 to lift off the nodules 45 or deposits of deposition material that may have formed on the sacrificial layer 34. The sacrificial layer 34 may be removed by any conventional technique, including the use of a solvent or an etching process. For example, photoresist materials may be removed using solvents such as acetone or EKC, polyimides may be removed by using polyimide strippers (e.g., Gamma-Butyrolactone) available from the polymer vendor or etched using CHF₃/O₂ etch process, and silicon dioxide may be etched using vapor HF and ethylene glycol. Accordingly, the sacrificial layer has served its purpose of shielding the dielectric layer 32 during CVD Al deposition and thereby eliminates the need for chemical mechanical polishing of the dielectric surface 43 to remove any nodules formed thereon. Furthermore, the top surface 43 of the dielectric layer 32 remains substantially planarized and in suitable condition for having additional layers formed thereon.

In another aspect of the present invention, a resist material that is stable at temperatures between about 120° C and about 240° C is used for the dual purposes of masking the etch of the aperture and acting as a sacrificial layer. The application of a dedicated sacrificial layer is avoided by leaving the resist in place until after the CVD Al process. Certain resists chosen for this simplified process, may require a post thermal treatment prior to the CVD Al process. However, the preferred resists, including deep ultraviolet photo resists (available from Shipley) and photosensitive polyimides are sufficiently stable without thermal treatment. Following this process, the dielectric layer is shielded from CVD Al formation by the resist in a similar manner as the dedicated sacrificial layer described above. Any CVD Al formed on the resist is lifted off during the removal of the resist by a solvent, such as acetone or EKC, or etch process, such as CHF₃/O₂.

According to this aspect of the invention, a completely selective CVD Al process is accomplished with no additional steps than are ordinarily required for etching apertures and chemical vapor depositing a metal. By simply delaying the resist removal step until after the selective CVD metal deposition step has formed the interconnect, the condition of the dielectric field is preserved.

In still another application, a dielectric such as silicon dioxide may be used as the sacrificial layer. Such applications include, depositing silicon dioxide over a low k polymer such as a polyimide. A photoresist is then deposited over the silicon dioxide so that the sacrificial layer and low k polymer can be patterned. The aperture formed therethrough is then selectively filled to form an interconnect. The silicon dioxide can then be etched away leaving the low k polymer free of any defects.

Both of the processes disclosed herein provide for selective metal interconnect formation even in high aspect ratio (>5:1), sub-quarter micron apertures. Both processes also preserve the condition of the dielectric field by maintaining a protective film over the dielectric layer until after the CVD metal interconnect has been formed. Furthermore, neither process requires chemical-mechanical polishing before proceeding with the formation of additional layers. While the foregoing has been directed to CVD Al, any CVD metal process can be used to advantage with the present invention.

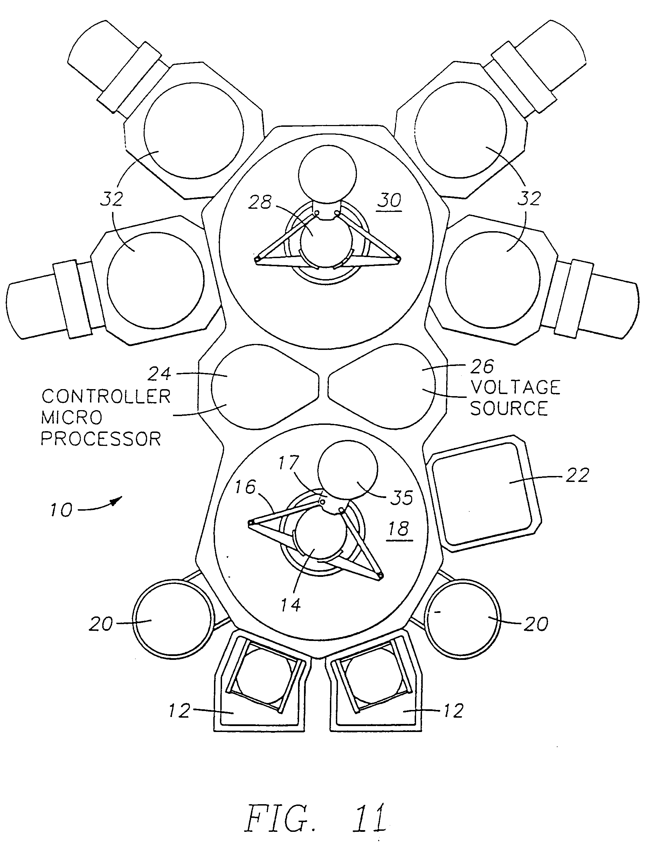

Referring to Figure 10, a transmission electron microscopy photograph shows a cross-section of a semiconductor substrate interconnect formed by the selective process of the present invention. Note that the crystal structure of the interconnects are substantially uniform having grown selectively upward from the floor of the aperture. It is also important to note the nodule-free surface of the dielectric field spanning between each interconnect.

Referring to Figure 11, a schematic diagram of an integrated cluster tool 60 is shown. Typically, substrates are introduced and withdrawn from the cluster tool 60 through a cassette loadlock 62. A robot 64 having a blade 67 is located within the cluster tool 60 to move the substrates through the cluster tool 60. One robot 64 is typically positioned in a buffer chamber 68 to transfer substrates between the cassette loadlock 62, degas wafer orientation chamber 70, preclean chamber 72, PVD TiN ARC chamber 74 and cooldown chamber 76. A second robot 78 is located in transfer chamber 80 to transfer substrates to and from the cooldown chamber 76, coherent Ti chamber 82, CVD TiN chamber 84, CVD Al chamber 86 and PVD AlCu processing chamber 88. The transfer chamber 80 in the integrated system is preferably maintained at low/high pressure vacuum in the range of 10⁻³ to 10⁸ torr. This specific configuration of the chambers in Figure 6 comprise an integrated processing system capable of both CVD and PVD processes in a single cluster tool. The chamber configuration is merely illustrative and should not be taken as limiting the application of the present invention.

Typically, a substrate processed in the cluster tool 60 is passed from the cassette loadlock 62 to the buffer chamber 68 where the robot 64 first moves the substrate into a degas chamber 70. The substrate may then be transferred into preclean chamber 72, PVD TiN ARC chamber 74, and then into a cooldown chamber 76. From the cooldown chamber 76, the robot 78 typically moves the substrate into and between one or more processing chambers 82, 84, 86, and 88 before returning the substrate back to the cooldown chamber 76. It is anticipated that the substrate may be processed or cooled in one or more chambers any number of times in any order to accomplish fabrication of a desired structure on the substrate. The substrate is removed from the cluster tool 60, following processing, through the buffer chamber 68 and then to the loadlock 62. A microprocessor controller is provided to control movement of the substrate throughout the system and the sequence and formation of the desired film layers on the substrates.

In accordance with the present invention, the cluster tool 60 passes a substrate through loadlock 62 into de-gas chamber 70 wherein the substrates are introduced to outgas contaminants. A substrate is then moved into a pre-clean chamber 72 where the surface of the substrate is cleaned to remove any contaminants thereon. The substrate is then moved by the robot 64 into cooldown chamber 76 in preparation of processing.

One staged-vacuum wafer processing system is disclosed in United States Patent No. 5,186,718, entitled "Staged-Vacuum Wafer Processing System and Method," Tepman et al., issued on February 16, 1993, which is hereby incorporated herein by reference.

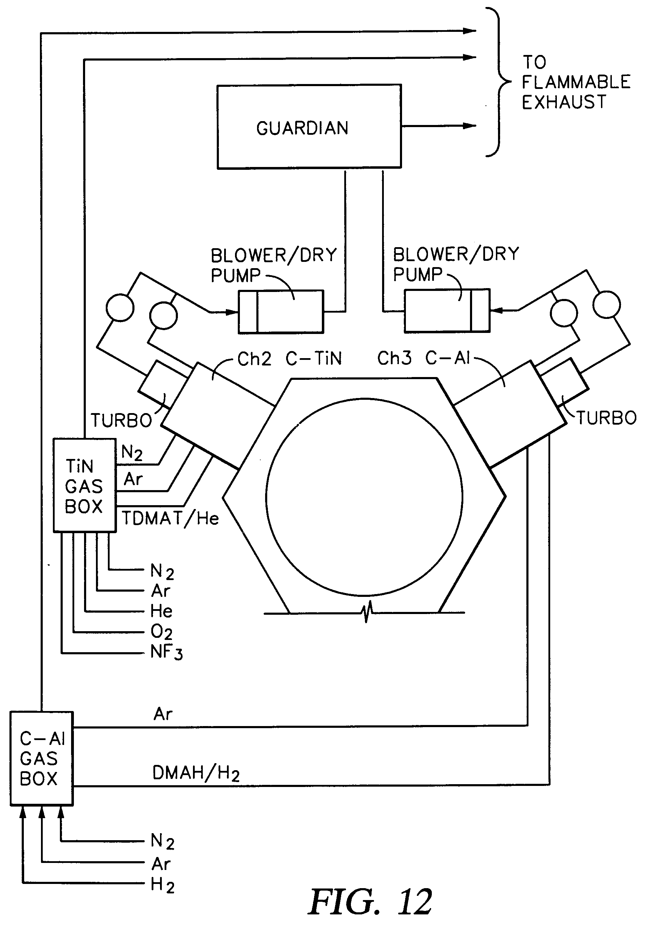

Referring to Figure 12, a gas box system for supplying gases to the CVD chamber of the system in Figure 6 is illustrated. The TiN gas box is supplied with N₂, Ar, He, O₂, NF₃ and H₂. The reaction product tetracus dimethyl amino titanium ("TDMAT"), along with the inert gas Ar and N₂, are passed into the CVD TiN chamber for processing. Similarly, a CVD Al gas box is supplied with N₂, Ar and H₂. The reaction product dimethyl aluminum hydride ("DMAH"), H₂ and the inert gas Ar are passed into the CVD Al chamber for deposition of aluminum. Both chambers are equipped with a turbo pump for providing a vacuum in the chamber and a blower/dry pump.

While the foregoing is directed to the preferred embodiment of the present invention, other and ether embodiments of the invention may be devised without departing from the basic scope thereof. The scope of the invention is determined by the claims which follow.

## Claims

1. A method for selectively filing an aperture in a substrate layer comprising the steps of:
a) forming a sacrificial layer over the surface of the substrate;
b) etching the sacrificial layer and substrate layer to form an aperture having a floor exposing a deposition enhancing material; and
c) selectively depositing a conductive material on the deposition enhancing material to fill the aperture, wherein some of the conductive material is deposited on the sacrificial layer; and
d) removing the sacrificial layer and the conductive material deposited on the sacrificial layer.

2. The method of claim 1, wherein the sacrificial layer is an organic material that can be removed by a solvent.

3. The method of claim 1, wherein the substrate layer is the uppermost portion of the substrate.

4. The method of claim 1, wherein the substrate layer is a film layer deposited on the substrate.

5. The method of claim 1, wherein the sacrificial layer is an organic material that is etchable.

6. The method of claim 1, wherein the sacrificial layer is a polyamide.

7. The method of claim 1, wherein the conductive metal is aluminum.

8. The method of claim 1, wherein the step of etching the sacrificial layer and substrate layer comprises the steps of:
coating the sacrificial layer with a photoresist;
patterning the photoresist to expose portions of the sacrificial layer;
etching the exposed portions of the sacrificial layer and substrate layer to form an aperture having a floor exposing the deposition enhancing material; and
removing the photoresist from the sacrificial layer.

9. The method of claim 6, wherein the step of patterning the photoresist comprises the steps of:
developing portions of the photoresist with light;
removing the undeveloped portions of the photoresist from the sacrificial layer;

10. The method of claim 1, wherein the steps are performed in an integrated processing chamber.

11. The method of claim 1, wherein the deposition enhancing material is an electron donor.

12. The method of claim 1, wherein the electron donor is an electrically conductive material.

13. The method of claim 1, wherein the electrically conductive material is a metal.

14. In a selective deposition process for forming interconnects through a dielectric layer, the improvement comprising the steps of:
a) forming a sacrificial layer over the dielectric layer before etching apertures through the sacrificial layer and dielectric layer;
c) removing the sacrificial layer and any materials formed thereon only after forming interconnects by selective chemical vapor deposition.

15. A method of selectively forming a conductive interconnect in a substrate having an underlying layer of a deposition enhancing material, comprising the steps of:
a) coating the substrate with a photoresist;
b) patterning the photoresist to expose portions of the substrate;
c) etching the exposed portions of the substrate to form an aperture having a floor exposing the deposition enhancing material;
d) selectively depositing a conductive material on the deposition enhancing material, wherein some of the conductive material is deposited on the photoresist; and
e) removing the photoresist and the conductive material deposited on the photoresist.

16. The method of claim 13, wherein the step of patterning the photoresist comprises the steps of:
developing portions of the photoresist with light; and
removing the undeveloped portions of the photoresist from the sacrificial layer.

17. The method of claim 13, wherein the steps are performed in an integrated processing chamber.

18. The method of claim 13, wherein the step of selectively depositing a conductive material on the deposition enhancing material comprises the step of:
reacting a CVD metal precursor on the deposition enhancing material to deposit the metal.

19. The method of claim 16, wherein the deposition enhancing material promotes the decomposition of the CVD metal precursor by donating an electron.

20. The method of claim 13 wherein the deposition enhancing material is an electron donor.

21. The method of claim 18, wherein the electron donor is an electrically conductive material.

22. The method of claim 19, wherein the electrically conductive material is a metal.

23. The method of claim 13, wherein the deposition enhancing material is electrically conductive member, and wherein the step of selectively depositing a conductive material on the deposition enhancing material comprises the step of:
electroplating a metal on the electrically conductive member.

24. A method of forming a dielectric layer having a metal interconnect therethrough, comprising the steps of:
a) forming a first dielectric layer over the surface of the substrate, wherein the dielectric layer is comprised of a polymer having a dielectric constant that is lower than the dielectric constant of silicon dioxide;
b) forming a second dielectric layer over the first dielectric layer, wherein the second dielectric layer is comprised of a material selected from the group consisting of silicon dioxide and silicon nitride;
c) etching the first and second dielectric layers to form an aperture having a floor exposing a deposition enhancing material; and
d) selectively depositing a conductive material on the deposition enhancing material to fill the aperture, wherein some of the conductive material is deposited on the second dielectric layer; and
e) removing a portion of the second dielectric layer and the conductive material deposited on the second dielectric layer.

25. The method of claim 24, wherein the step of etching the first and second dielectric layers comprises the steps of:
coating the second dielectric layer with a photoresist;
patterning the photoresist to expose portions of the second dielectric layer;
etching the exposed portions of the sacrificial layer and substrate layer to form an aperture having a floor exposing the deposition enhancing material; and
removing the photoresist from the sacrificial layer.
